# EUROPEAN PATENT SPECIFICATION

(11) **EP 4 092 432 B1**
(45) Date of publication and mention of the grant of the patent: **02.07.2025**
(21) Application number: 21174136.8
(22) Date of filing: 17.05.2021
(51) Int. Cl.: G01R 31/36

(54) **A BATTERY POWERED DEVICE AND METHOD IN A BATTERY POWERED DEVICE**
BATTERIEBETRIEBENE VORRICHTUNG UND VERFAHREN IN EINER BATTERIEBETRIEBENEN VORRICHTUNG
DISPOSITIF ALIMENTÉ PAR BATTERIE ET PROCÉDÉ DANS UN DISPOSITIF ALIMENTÉ PAR BATTERIE

(43) Date of publication of application: 23.11.2022
(60) Divisional application: 24156521.7
(73) Proprietor: Verisure Sàrl, 1290 Versoix, Geneva (CH)
(72) Inventor: RYD, Patrik, 1290 Versoix (CH)
(74) Representative: Dennemeyer & Associates S.A.

(56) References cited:
- WO-A1-2008/082288
- WO-A1-2020/039044
- US-A1- 2003 069 704
- US-B2- 9 407 098

## Description

### Technical Field

The present invention relates to a method of determining battery status in a battery powered device, a method of controlling a battery powered device based on an identification of a battery chemistry or type, and to battery powered devices configured to implement the methods.

### Background

Battery power is often used in preference to other power supplies, such as networked "mains" power supply or an intermittent or unreliable one such as solar, wave or wind, where continuity of supply is required together with a freedom to locate the device being powered without the constraint of having a wired connection. For example, in security monitoring systems, such as domestic burglar alarms and the like, as e.g. disclosed by WO-A1-2020/039044, peripherals such as glass-break detectors, movement sensors, door/window sensors, video cameras, and microphones, are preferably battery-powered so they can be situated wherever is most appropriate or most convenient without the need to run an electrical supply line. A problem with battery power is that, unlike "mains" electricity, the amount of power available is limited - so that eventually the batteries need to be replaced before they completely exhausted, to avoid the peripheral from ceasing to operate. Obviously, the proper operation of a security monitoring system is critically dependent upon the proper functioning of the various peripherals of the system.

US-A1-2003069704 discloses a use-adaptive fuel gauging for battery powered electronic devices.

Although at the design stage it is possible to plan for a certain battery lifetime, in practice the same device will flatten its batteries at different rates depending upon the activity of the device, which depends upon its location and other factors. So we want to know when the battery the device needs changing, before it needs changing, but we also want to avoid changing batteries too soon because there is an expense and an opportunity cost (e.g. fixing an appointment for a service engineer to visit, and ensuring the visit takes place) to changing batteries. It is known to monitor energy consumption in battery-powered devices, so that an "end of life" warning can be given before the battery power supply ceases to have enough power to run the device correctly. For example, it is known to provide what are known as "fuel gauges" which use a technique such as "Coulomb counting" to monitor the amount of energy consumed by device. When the fuel gauge determines that a battery power supply is sufficiently depleted, an alarm of some kind is raised. Unfortunately, such fuel gauges themselves consume power. In security monitoring systems the power constraints for peripheral devices are severe, because a design goal is to have an average battery life of more than two years for every peripheral, and in many cases the target battery life is as much as five years. Of course, most security monitoring systems fortunately see very few security events each year, although they may see a greater number of false alarms. This means that most of the energy in a battery power supply for such a peripheral is used running the peripheral in a sleep mode or an idle mode, rather than in dealing with an alarm event. Against this background, the use of a fuel gauge arrangement to monitor energy consumption is contrary to the ideal of reducing energy drain in the usual idle or sleep states.

Another problem which needs to be addressed is how to deal with the variability in the amount of energy provided by a new set of batteries, when the energy content of batteries that are externally essentially identical vary very significantly, being critically dependent both upon the battery chemistry and even the brand of the battery.

There therefore exists a need for a method of determining battery status in a battery powered device, and for a method of controlling a battery powered device based on an identification of a battery chemistry.

### Summary

In a first aspect there is provided a battery powered electronic device comprising: a first part that includes an electronic controller to control the operation of the device; a second part, controlled by the controller, which uses battery power only when energised and which is energised only intermittently;
wherein the power consumption of the second part is greater than that of the first part;
a battery power supply;
a "fuel gauge" to record the amount of energy consumed by the second part, optionally using coulomb counting, the fuel gauge only being activated when the second part is activated;
a monitoring arrangement, distinct from the fuel gauge, to monitor the amount of time that the controller spends in each of multiple activity states;
the device (controller/monitor) being configured to:
   estimate the amount of energy consumed by the first part based on knowledge of the energy usage of the first part in each of the multiple activity states;
   determine an initial energy capacity of the battery power supply based on an identification of the battery power supply;
   determine the remaining energy capacity of the battery power supply based on the determined initial energy capacity, the estimate of the amount of energy consumed by the first part, and
   the record from the fuel gauge of the amount of energy consumed by the second part; and, if the remaining energy capacity is determined to be less than a predetermined amount, generate a signal to indicate that it is time to replace the battery power supply.

Preferably the device is configured to identify the battery power supply by determining the battery chemistry of the battery power supply. Because batteries of the same external configuration - e.g. AA, AAA, D, typically have very different energy capacities, it is useful to be able to identify the chemistry of a battery so that use can be made

Optionally, the device is configured to determine the battery chemistry by comparing battery voltage measurements made after a first interval from initial use of the battery power supply, and again after a second longer interval. Optionally, the first interval corresponds to a first predetermined quantity of energy used from the battery power supply, and the second interval corresponds to a second predetermined quantity of energy used from the battery power supply. Optionally, the first predetermined quantity of energy is between 1 and 5% of the initial energy content of the battery power supply. Optionally, the second predetermined quantity of energy is greater than the first predetermined quantity of energy and is between 12 and 25% of the initial energy content of the battery power supply.

Preferably, the device is also configured to identify the battery power supply by determining the type of battery in the battery power supply. The type may equate with a brand or product specification.

Optionally, the type of battery is determined based on a comparison of a measured voltage drop with a stored reference value for alkaline batteries.

Preferably the type of battery is determined based on a comparison of results of the comparison of battery voltage measurements with stored reference values for known types of batteries.

Preferably reference values are stored for known types of batteries of at least two different battery chemistries.

Preferably, the device is configured to identify at least alkaline and lithium battery chemistries.

Preferably the device of the first aspect is configured to estimate the amount of energy consumed by the main part of the device based on knowledge of the energy usage of the first part in each of a sleep state and one or more active states. Preferably, the one or more active states include a radio receiving state and a radio transmitting state. Preferably the device is configured to estimate the amount of energy consumed by the main part of the device based on knowledge of the energy usage of the first part in an idle state.

Preferably the device of the first aspect further comprises a store that stores a power usage value for the first part in each of the multiple activity states.

Optionally the device is an intelligent peripheral of a security monitoring system, for example a video camera for such a system. Preferably, the second part comprises an image sensor and a video processor, and optionally a Wi-Fi transceiver. Preferably, the first part comprises a transceiver for communicating with a controller of the security monitoring system, optionally a transceiver operating in ISM radio bands.

According to a second aspect, there is provided a method of determining battery status in a battery powered device having a main part that is always on and that includes an electronic controller to control the operation of the device, and a battery power supply, the method comprising:
using coulomb counting to determine the energy consumption of a sub-unit of the device, the sub-unit being energised only intermittently and using battery power only when energised;
estimating the amount of energy consumed by the main part of the device based on knowledge of the energy usage of the first part in each of the multiple activity states and the cumulative time spent in these states;
determining an initial energy capacity of the battery power supply based on an identification of the battery power supply; and
determining the remaining energy capacity of the battery power supply based on the determined initial energy capacity, the estimate of the amount of energy consumed by the first part, and the record from the fuel gauge of the amount of energy consumed by the sub-unit.

Preferably, estimating the amount of energy consumed by the main part of the device is based on knowledge of the energy usage of the first part in each of a sleep state and one or more active states. Preferably, the one or more active states include a radio receiving state and a radio transmitting state. Preferably, estimating the amount of energy consumed by the main part of the device is based on knowledge of the energy usage of the first part in an idle state.

Estimating the amount of energy consumed by the main part of the device may be based on power usage values for the first part in each of the multiple activity states.

Optionally, estimating the amount of energy consumed by the main part of the device in each of the multiple activity states is based on activity periods as short as 1 millisecond, and optionally as short as 0.1 millisecond.

Optionally, estimating the amount of energy consumed by the main part of the device in each of the multiple activity states is based on activity periods as short as the period of a system clock of the device. Although this is an extremely short period, the clock is already available and using a short period can help achieve high accuracy in power usage estimation.

Optionally, if the remaining energy capacity is determined to be less than a predetermined amount, generating a signal to indicate that the battery power supply needs to be replaced. Preferably such a signal is transmitted to the central unit of the security monitoring system, from where it may be onward transmitted to a central monitoring station so that a service engineer may be dispatched to change the battery pack. Alternatively or additionally, the device may include an audio output device to emit a signal indicative of the need to change the battery pack - in this way, the user of the system is also alerted of the need to change the battery pack. Depending upon the circumstances, a user may be permitted to change a battery pack when the system is disarmed.

Preferably, the method of the second aspect further comprises identify the battery power supply by determining the battery chemistry of the battery power supply. Although there are significant differences between the available energy capacity of different brands of alkaline cells, and likewise for lithium chemistry cells, there is generally a bigger difference between cells of the two chemistries.

Preferably, the device is configured to determine the battery chemistry by comparing battery voltage measurements made after a first interval from initial use of the battery power supply, and again after a second longer interval. In this way it may be possible to identify the battery type with high accuracy, meaning that a better estimate can be made of remaining battery life. In particular, we select the second longer interval on the basis that we want the expected voltage drop to be large if alkaline batteries are used, because there are some uncertainties like temperature and difference between brands.

Preferably, the first interval corresponds to a first predetermined quantity of energy used from the battery power supply, and the second interval corresponds to a second predetermined quantity of energy used from the battery power supply.

Optionally, the first predetermined quantity of energy is between 1 and 5% of the initial energy content of the battery power supply. In this way, we can be sure that we have come past the initial voltage drop point for lithium chemistry batteries.

Optionally, the second predetermined quantity of energy is greater than the first predetermined quantity of energy and is between 12 and 25% of the initial energy content of the battery power supply. After such a significant power usage, the reliability of determining battery type may be greatly increased, while the bulk of the initial energy quantity remains to be used - so that adjustment of operating parameters, such as frame rate and resolution can be performed over the bulk of the life of the battery pack, thereby helping to achieve good battery life irrespective of the type of battery installed.

Optionally, the battery power supply may be identified by determining the type of battery in the battery power supply. For example, by determining that the battery type is a recognised Energiser, Panasonic, or Duracell battery- although in practice the particular brands supported may all be different from these examples. The determination of battery type may, for example, be achieved by the setting of a switch or the like when a battery power supply is initially installed.

Optionally, determining the type of battery may be based on a comparison of a measured voltage drop with a stored reference value for alkaline batteries.

Optionally, the type of battery may be determined by comparing results of a comparison of battery voltage measurements with stored reference values for known types of batteries.

Optionally, in the method of the second aspect comprises comparing results of a comparison of battery voltage measurements with stored reference values for known types of batteries of at least two different battery chemistries.

Optionally, in the method of the second aspect further comprising determining whether the chemistry is an alkaline or a lithium chemistry.

### Description of Figures

Embodiments of the invention will now be described, by way of example only, with reference to the accompanying drawings, in which:
Figure 1 is a schematic block diagram of a device, according to an aspect of the invention, in the form of a video peripheral for a security monitoring system;
Figure 2 plots the supply voltage of battery power supply against the amount of energy supplied for 3 types of batteries for each of two chemistries at a single temperature;
Figure 3 plots the supply voltage of battery power supply against the amount of energy supplied for 2 types of batteries, one for each of two chemistries, at different temperatures; and
Figure 4 is a schematic diagram of a security monitoring system including a video peripheral of the type illustrated by Figure 1.

### Specific description

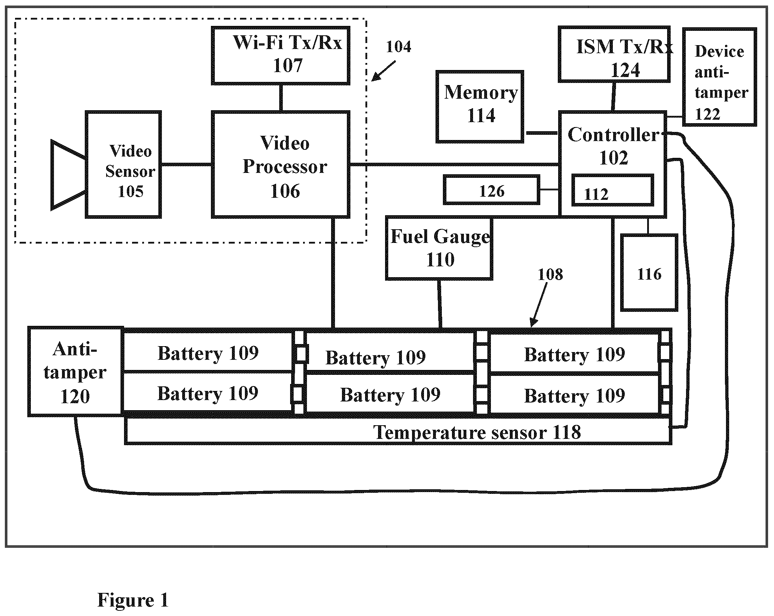

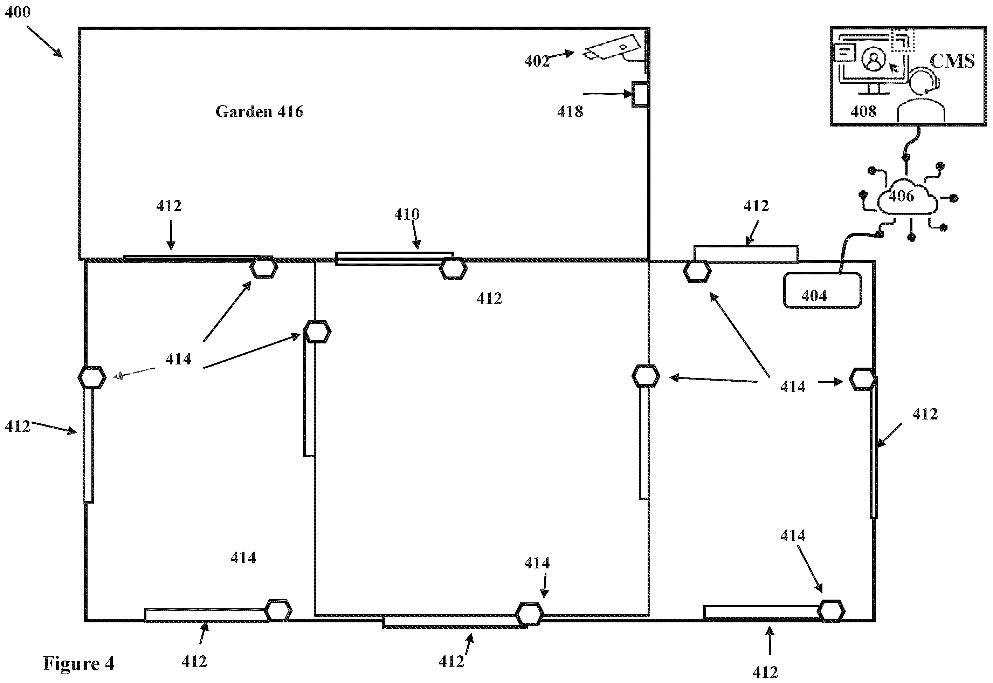

Figure 1 shows a battery-powered electronic device 100. The device comprises a first part, that includes an electronic controller 102 to control the operation of the device, and the second part 104, controlled by the controller 102, which uses battery power only when energised and which is energised only intermittently. The second part 104 of the device has a power consumption that is greater than that of the first part. In the illustrated example the electronic device 100 is a peripheral of a security monitoring system, details of which will be described later with reference to Figure 4, specifically a video camera peripheral. As can be seen, the second part 104 includes a video sensor 105, which is coupled to a video processor 106 which is in turn coupled to a Wi-Fi transceiver 107. This second part 104 is off, drawing no power from the battery power supply 108, when the peripheral is in standby mode - which is most of the time. Conversely, the first part of the device, which may be considered to be the main part, draws power from the battery power supply 108 all the time, even when the first part is in a sleep state.
The second part 104 consumes a lot of energy when it is taking photos, streaming video or sending images over Wi-Fi. The video processor 106 is an image signal processor (ISP) used for photo capture and controlling the Wi-Fi module 107. A suitable ISP device is the Omnivision OA7000. The Wi-Fi transceiver may conveniently be provided by an RAF module such as a Cypress Semiconductor CYW43012, which is an ultra-low-power Wi-Fi and Bluetooth device which is compliant with IEEE 802.11n.
The battery power supply 108 is here illustrated as including six battery cells 109, which are arranged in two pairs of three series-connected cells. For example, the battery cells 109 may each be AA batteries, arranged to provide a nominal battery power supply voltage of 4.5 V. Clearly, the number, type, voltage, and arrangement of batteries within the battery power supply is not constrained, and the invention is clearly applicable to any battery power supply configuration.

The device further comprises a battery fuel gauge 110, coupled to the battery power supply 108 and the controller 102. Conveniently, the battery fuel gauge is, for example, a BQ35100 device from Texas Instruments, although suitable alternatives may be obtained from other manufacturers. With the battery fuel gauge 110 makes accurate voltage, temperature, current, and Coulomb counter measurements that report battery health and service life. The BQ35100 has a state of health (SOH) algorithm for lithium manganese dioxide batteries, and an end of service (EOS) algorithm for LiSOCL2 batteries, as well as a Coulomb accumulation (ACC) algorithm for all battery types. Texas Instruments quote a current consumption of approximately 0.06 micro amps for the SOH algorithm, approximately 0.35 micro amps for the EOS algorithm, and approximately 0.3 micro amps for the ACC diagnostic update. Although these current figures are commendably low, peripheral devices for security monitoring systems are required to have very long battery lives - typically the battery lifetime of a peripheral is required to be at least two years, and more preferably three or more years, and it would be difficult if not impossible to achieve such battery lifetimes if the fuel gauge 110 were used to monitor all power consumption of the electronic device. Consequently, we propose using the fuel gauge to record the amount of energy consumed by the second part 104 the fuel gauge only being activated when the second part is activated. However, as previously mentioned, the peripheral device 100 is "always on", and hence we need to take account of the energy consumption of the main part if we are to keep track of the condition of the battery power supply 108, so that we know in advance when it is necessary to replace the battery power supply. In order to address this need we provide a monitoring arrangement 112, which is distinct from the fuel gauge 110.

The monitoring arrangement 112 is shown schematically as a module within the controller 102 - although in practice the monitoring arrangement will typically be implemented as an algorithm or software routine run by the controller 102, the algorithm or software routine being stored, for example on memory 114. The monitoring arrangement 112 is arranged to monitor the amount of time that the controller 102 spends in each of multiple activity states. For example, the controller 102 will typically have a sleep state, and one or more active states. The active states may include an idle state, a radio receiving state, and a radio transmitting state. Other active states may also be recognised. The monitoring arrangement 112 is arranged to monitor the amount of time that the controller spends each of these states. The power consumption in each of these states is determined at the pre-production stage. The amount of current used in the identified states is measured in advance. Preferably the measurements are done at more than one supply voltage, e.g. one low-voltage and one high-voltage, to reflect the changes in battery supply voltage that occur over the lifetime of a set of batteries. The corresponding power consumption values for each of the states is stored in memory in the device. In determining how much energy is being used, the monitoring arrangement 112 identifies the relevant state and then interpolates between the stored current values for the high and low voltage, based on the current voltage. The estimation is then done by measuring the amount of time spent on each of the different states. This is preferably done to a good degree of accuracy for example based on activity periods as short as 1 ms, optionally as short as 0.1 ms. The real-time clock associated with the processor 102 can be used as the basis for the activity periods measured. Therefore, with knowledge of the amount of time that the controller has spent in each state, and the known power consumption values, it becomes possible to estimate the amount of energy consumed by the first part.

The controller/processor 102 is preferably provided as part of a system on chip (SoC) device such as one of Silicon Labs' EFR32FG13 family of devices, which have a 32-bit Arm processor, sub-GHz radio transceivers, e.g. for ISM 868MHz and other frequencies, and which may be used with 32.xKhz crystal for the RTC. Thus with such a device, or a comparable one, the measurement of states over the controller 102 may be as short as the clock cycle of the RTC.

In order to determine the amount of energy remaining in the battery power supply, it is necessary to know the initial energy capacity of the battery power supply. Although we may know the contents of the battery power supply in terms of the number and configuration of the cells that make up the power supply, for example in the illustrated example we have six AA cells, this is insufficient to tell us the initial energy capacity. This is because the energy content of AA batteries varies not just between competing chemistries, for example alkaline and lithium chemistries, but also between different brands of cells with nominally the same chemistry. So, for example the best alkaline AA batteries may contain up to 50% more energy than the worst alkaline double a batteries. Likewise, there is a great disparity between the energy content of the best and worst lithium chemistry batteries. It is useful therefore to know what type of cells are included in the battery power supply. At a simple level, the type of cells could be captured, on installation, by the installer setting a selector 116 to indicate the chemistry, for example alkaline or lithium - perhaps by setting a switch accordingly. Preferably the device includes an additional selector to enable the installer to indicate the brand of battery that has been installed. Energy capacities for each of the brands of battery that can be indicated through the additional selector are stored in the device, for example in memory 114, so that the controller 102 can determine an initial energy capacity of the battery power supply based on an identification of the battery power supply. The controller or processor 102 is then able to determine the remaining energy capacity of the battery power supply based on the determined initial energy capacity, the estimate of the amount of energy consumed by the first part, and the record from the fuel gauge 110 of the amount of energy consumed by the second part 104.

Optionally, the controller 102 may then, if the remaining energy capacity is determined to be less than a predetermined amount, generates a signal to indicate that it is time to replace the battery power supply.

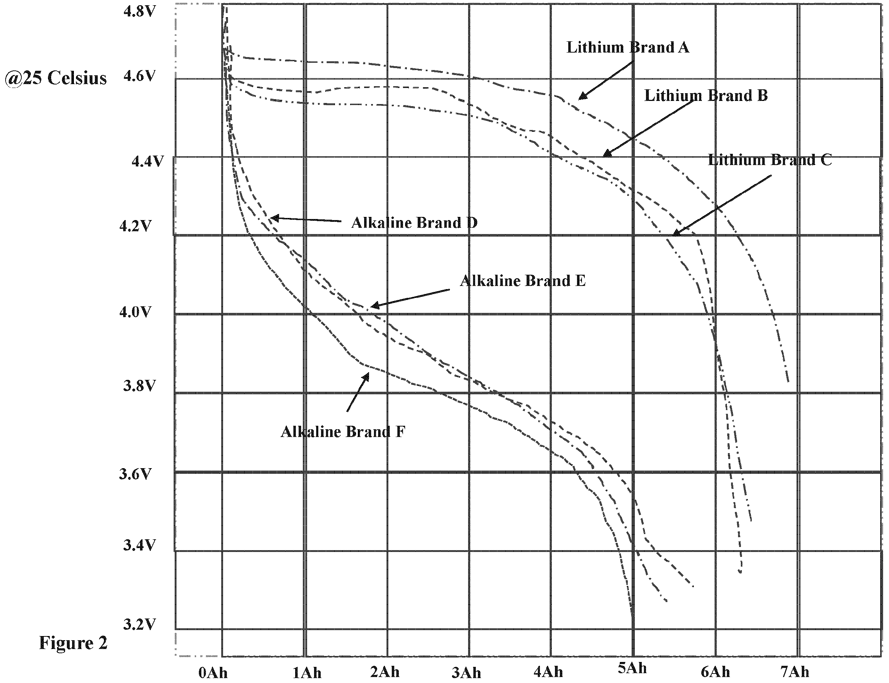

Although, as previously described, the device may include one or more battery type selector 116, and installer may forget to reset the selector, or may set it incorrectly. Consequently, the device is preferably configured to perform the process by means of which it can identify the battery chemistry, and preferably also identify the type of battery - i.e. the brand or model of the battery, from amongst a selection of known battery brands for which energy storage data is stored in the device. To do this, the devices configured to compare battery voltage measurements made at two different times. The approach will now be described with reference to figure 2 which shows output voltage plotted against the amount of energy withdrawn from the battery, for three notional brands of lithium chemistry battery, A, B and C, and three notional brands of alkaline chemistry battery, D,E, and F. It will be recognised that the plot corresponds to the battery pack illustrated in figure 1, that is a battery pack arranged to supply and nominal voltage of 4.5 V, using six AA batteries arranged in two parallel stacks of three batteries connected in series. It can be seen that initially the battery pack provides in excess of 4.6 V, with some of the brands of lithium batteries supplying up to around 4.8 V. Importantly the plots for the six battery types overlap very significantly at this stage where little power has been drawn from the battery pack. It will be seen that the plots for the two different chemistries start to diverge significantly after about 0.2Ah of energy has been consumed with a very striking difference in supply voltage appearing by the time 0.5 Ah has been consumed. It is from around this point that significant differences in the behaviour of the different alkaline brands emerges, whereas differences between the different lithium brands are discernible earlier. By keeping track of the amount of energy supplied to the device from the battery power supply 108, the processor 102 can run a check of supplied battery voltage after sufficient energy has been supplied for the differences between the supply voltages of the different chemistries to become clearly discernible. After performing one such check, after for example 0.3 Ah has been supplied, the processor 102 should be able to determine whether the type selector 116 has been correctly set, at least in terms of chemistry. Performing a second such check later, for example when the amount of energy supplied is between 0.5 and 1.5 Ah, for example 1.0 Ah should enable the processor to be to identify the type of alkaline battery, or type of lithium chemistry battery, that has been installed, based for example on the voltage drop between the first check and the second check. At each stage, the processor can calculate the amount of energy remaining in the battery power supply.

It can be seen from figure 2 that lithium chemistry batteries are typically able to supply a voltage close to the nominal battery supply voltage of 4.5 V for much longer than are alkaline batteries. In fact, alkaline cells tend to be rather poor at delivering anything like their full rated capacity, which might be in the region of 2500mAh, unless they are supplying at very low currents. For an application such as a video camera peripheral for a security monitoring system the current demand is sufficiently great that alkaline cells may only deliver less than half their full rated capacity. So that a battery pack with 6 AA cells may only have an effective power rating of as little as 4200mAh. Conversely, lithium chemistry cells are much better able to supply near their full rated capacity even when supplying at quite high currents. With this in mind, a device such as the peripheral shown in figure 1, which occasionally requires quite high supply currents, is preferably arranged to adjust its performance based on the chemistry of the cells fitted in the battery power supply. The energy requirement of the second part of the device, that in the figure 1 embodiment includes the image sensor, the camera video processor, and the RF microcontroller, depends to some extent and configurable settings such as frame rate, resolution, RF transmitter power and bandwidth. If lithium chemistry batteries are fitted it may be possible to stream video at 30 frames a second, at a resolution of 1080P, in full colour, using a wider bandwidth and hence high speed Wi-Fi connection - given that in practice the peripheral is rarely called upon to transmit video. All this may be achieved while still achieving the design battery lifetime. Conversely, if the battery power supply is fitted with alkaline cells it may be impossible to achieve the design battery lifetime unless the performance of the second part is reduced, for example by significantly reducing the frame rate, by reducing the resolution significantly, by sending monochrome rather than full-colour images, and by reducing the bandwidth and/or transmission power of the Wi-Fi transmitter. With this in mind, once the processor 102 has determined the battery chemistry, it preferably configures the second part, in particular the ISP and the RF microcontroller, etc. to reduce energy consumption and hence prolong useful battery life.

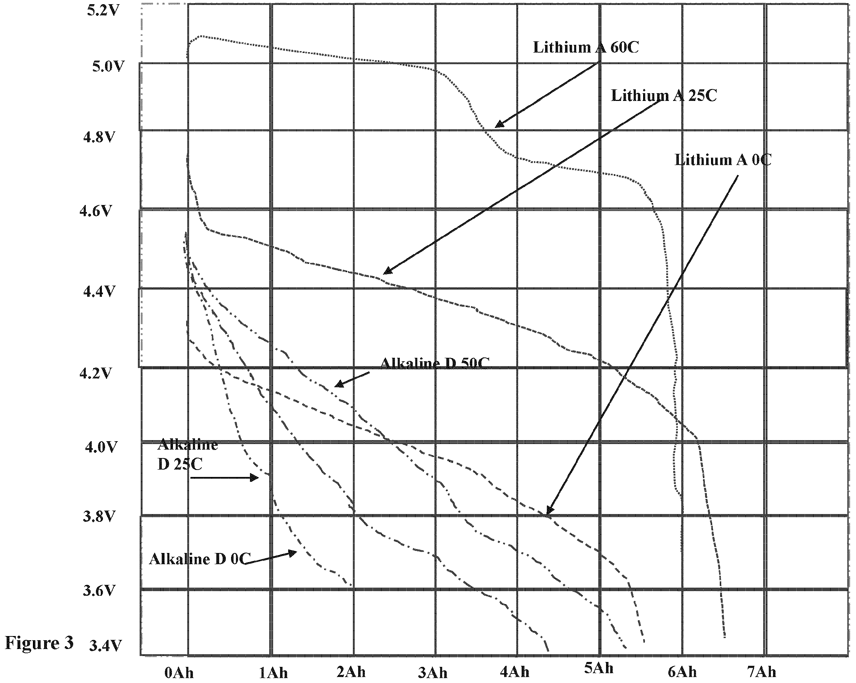

A further complication arises from the fact that the supply voltage of a battery, whether alkaline or lithium chemistry, may vary very significantly over the temperature range to which a peripheral of a security monitoring system may be exposed - especially if the peripheral is mounted outside. This is represented schematically in Figure 3 which shows how the voltage supplied from a battery power supply such as that in figure 1 varies according to temperature for an example of an alkaline chemistry battery and an example of a lithium chemistry battery. Basically, if the battery is hot, i.e. at 25°C or above, it can supply a significantly higher voltage for longer than it could if it were at 0°C. Consequently, particularly if the peripheral is mounted outside or somewhere else where it may be exposed to extremes of temperature - a cold store, a factory, or processing plant, the device is preferably configured to take account of the temperature of the battery pack - or at least of the ambient temperature. Preferably therefore a temperature sensor 118 is provided as part of the battery power supply or as part of the device adjacent the battery power supply. Then, when estimating the amount of energy left in the battery power supply, the controller 102 deducts the estimate of the amount of energy consumed by the first part and the record from the fuel gauge of the amount of energy consumed by the second part from the initial energy capacity of the battery pack, and then adjusts its estimate of the remaining energy capacity based on its knowledge of the current temperature and the temperature performance of the battery chemistry/type known to be installed.

### When to change the batteries

One of the benefits of the present invention is that the processor 102 is able to estimate fairly accurately the amount of available energy remaining in the battery power supply. As noted earlier, for many applications, including in particular for peripherals of a security monitoring system such as the video device shown in figure 1, it is important not to let the battery power dropped so low that the device is no longer able to perform its function - which is to contribute to the proper functioning of the security monitoring system. In other words, we don't want the battery power to full so low that, in the event of an incident, the camera is no longer able to capture and share images or video with the controller of the security monitoring system. It is generally established that a peripheral in the security monitoring system should indicate the need for a battery change at least 30 days before the battery powerful so low that the peripheral cease working. For a device such as the video peripheral of figure 1 we want the batteries to have sufficient power not only to support an idle or sleep state for 30 days, but we also want to be able to capture a burglary attempt or a false alarm within this period. We therefore factory in the amount of energy required for the peripheral to handle the events associated with a burglary attempt or a false alarm and add this to what can be regarded as a safe margin on top of an average 30 days battery life: we treat the resulting energy total is the minimum before which the peripheral will report a low battery condition. Depending upon the logistics supporting battery replacement, which may involve a visit from a service engineer, it will generally be prudent to budget for at least a 60 day energy capacity in addition to the amount of energy required for handling the events associated with a burglary attempt or false alarm. Optionally, the amount is increased to cover a 90 day energy capacity, in addition to the amount of energy required for handling the events associated with burglary attempt or false alarm.

The device may also be configured to keep track of how much energy has been used per day for the last 30 days, and a sliding window basis. Based on this history, an average usage per day can be calculated. And based on that value, an estimate is produced of the number of days the device can continue to run, taking account of how much has been consumed so far, the energy required two handle one burglary attempt or force alarm, the full battery pack capacity, and adjusted for temperature. If the expected number of days is less than a target number of days, e.g. 90 days, 60 days, or 45 days, the device transmits a low battery alert signal to the controller of the security monitoring system. The alert signal may then be onwards transmitted to a central monitoring station that supports the security monitoring system, so that for example, a service engineer could be called out to replace the batteries.

Figure 1 also shows a battery anti-tamper arrangement 120 which is designed to trigger the controller 102 into sending a tamper alert signal to the controller of the security monitoring system in the event that an attempt is made to remove the batteries from the device. A device anti-tamper arrangement 122 is also provided so that a tamper alert signal will also be sent to the controller of the security monitoring system in the event that an attempt is made to remove the device from its fixed position. Also shown in figure 1 are an ISM transceiver 124, which may be part of the previously mentioned EFR SoC, and crystal oscillator 126 which is used by the RTC of the processor 102 (e.g. the EFR SoC).

Figure 4 illustrates schematically a premises 400 within which a security monitoring system is installed. The security monitoring system includes a video peripheral 402, corresponding to the device of figure 1, or controller, 404 which is connected via the Internet 406 to a central monitoring station 408, at which human operators are stationed to respond to security alerts received from multiple security monitoring systems. Each of the external doors 410 and windows 412 of the premises 400 is provided with a peripheral 414 in the form of a shock sensor or magnetic switch arrangement, each of which is battery powered and provided with a radio transceiver to communicate with the central unit 404. The video peripheral 402 is externally mounted to protect the garden 416 of the premises, and is associated with a movement sensor, such as a PIR, 418. The movement sensor 418, which also includes a transceiver, signals to the central unit 404 in the event of detecting movement in the garden 416, and may also directly communicate with the video peripheral 402 so that the video peripheral may start to capture images. The central unit 404 may respond to receipts of a movement detection report from the movement sensor 418 by instructing the video peripheral 402 to send images or to stream video to the central unit. Images and/or video received from the video peripheral 402 may then be passed to the central monitoring station 408 where they are reviewed by a human agent who determines whether the images/video suggest that a security event is in progress. The central unit 404 may also activate a siren, and/or flashing lights, at the premises to warn of an intrusion.
1. We know the battery capacity of each of several battery brands of two or more types.
2. When a new set of one or more batteries is installed, ideally we inform the device of the type of battery installed (e.g. alkaline or lithium chemistry) and also the mAh rating of the battery pack, i.e. how much power is available from a full battery pack - e.g. 4200mAh, 5200 mAh, 5700mAh, 6400mAh : the latter may be indicated by setting a switch marked with the names of the selected brands which we support. We thus know how much energy the installed set of batteries contains.
3. The device includes one processor that is energy hungry (the "camera video processor" ISP) and that is used to control the camera, Wi-Fi and streaming videos, and a second less energy hungry one that is always on and that is in overall control and that controls the 868 ISM radio.
4. We want to track usage of the battery so that we don't run out of battery power without warning, and we also use knowledge of the battery power level in deciding how to run the device - in particular adjusting resolution, frame rate, etc. as necessary to enable us to schedule a battery replacement before the battery expires. Knowledge of the battery type can also be used in determining energy management strategies to ensure acceptable battery life longer term.
5. The device includes "fuel gauge hardware", which uses a technique called "coulomb counting" that provides a measure of the amount of "energy" consumed.
6. The fuel gauge hardware itself consumes energy when it is being used, we therefore only use this hardware while the device is using significant amounts of energy - which equate to the times when the camera video processor is active. The EFR decides when the ISP is turned on/off.
7. The peripheral is intended to spend most of its time in a low-power state, when the ISP is off, only being fully active for (rare/unusual) events that happen infrequently and which are of limited duration. We therefore want to be able to account for energy consumption when the ISP is inactive and without using the fuel gauge hardware.
8. We could try to replicate the fuel gauge approach and use this to monitor the EFR's energy consumption, but then we are likely to use a significant amount of power (over time) just to determine power usage - which is unattractive. We need a different approach.
9. Although the amount of energy used by the EFR depends upon its state, we want to estimate energy usage without incurring the energy cost of the conventional fuel gauge. We do this by identifying different energy usage states of the EFR, determining an average energy usage rate (power consumption) for each of the states, monitoring the energy state of the EFR over time (measuring the amount of time that the EFR spends in each state over a monitoring window) , and then calculating the total EFR energy consumption (for the whole monitoring window) based on the time spent in each state and the determined energy usage per state.
10. The total energy usage up to at any moment is the sum of the energy usage recorded by the fuel gauge and the estimate arrived at in 9 above.
11. Adjust for temperature
12. We also check the type of batteries installed (just in case the installer forget to reset, or reset wrongly, the battery type indicator): we do this by measuring the voltage when only the EFR is drawing current. once the device has consumed a first amount (e.g. 300mAh when, as here, we have a battery power supply using 6 x AA cells arranged as two parallel sets of three series-connected batteries and then again when it has used a second amount (e.g. 1000 mAh - or just over 3 times the initial amount, although 2 times, or between 2 and 3 times might work as well and provide earlier confirmation). What determines the length of time (i.e. the quantum of energy usage) before we take the second measurement is that we want the expected voltage drop to be large if alkaline batteries are used, because there are some uncertainties like temperature and difference between brands. A battery power supply using 6 x AA cells may typically have an energy content of between 4200mAh and 6400mAh. A power usage of between say 12 and 25% of the initial energy capacity is a reasonable ball park to achieve a reliable result. We have used a quantum of 1000mAh to good effect, but equally good results are to be expected with a quantum of 800 mAh, or between 800mAh and 1000mAh. Of course a larger quantum could be used to good effect, but there is then less residual energy to be managed, so the effects of managing current usage, by adjusting bit rate and frame rate, for example, are obtained for less of the energy usage from the battery power supply, which is non-optimal.

## Claims

1. A battery powered electronic device comprising: a first part that includes an electronic controller to control the operation of the device;
a second part, controlled by the controller, which uses battery power only when energised and which is energised only intermittently;
wherein the power consumption of the second part is greater than that of the first part;
a battery power supply;
a fuel gauge to record the amount of energy consumed by the second part, optionally using coulomb counting, the fuel gauge only being activated when the second part is activated;
a monitoring arrangement, distinct from the fuel gauge, to monitor the amount of time that the controller spends in each of multiple activity states;
the device being configured to:
estimate the amount of energy consumed by the first part based on knowledge of the energy usage of the first part in each of the multiple activity states;
determine an initial energy capacity of the battery power supply based on an identification of the battery power supply; and
determine the remaining energy capacity of the battery power supply based on the determined initial energy capacity, the estimate of the amount of energy consumed by the first part, and
the record from the fuel gauge of the amount of energy consumed by the second part.

2. The battery powered electronic device of claim 1, wherein the device is further configured, if the remaining energy capacity is determined to be less than a predetermined amount, generate a signal to indicate that it is time to replace the battery power supply.

3. The battery powered electronic device of claim 1 or claim 2, wherein the device is configured to identify the battery power supply by determining the battery chemistry of the battery power supply.

4. The battery powered electronic device of claim 3, wherein the device is configured to determine the battery chemistry by comparing battery voltage measurements made after a first interval from initial use of the battery power supply, and again after a second longer interval.

5. The battery powered electronic device of claim 4, wherein the first interval corresponds to a first predetermined quantity of energy used from the battery power supply, and the second interval corresponds to a second predetermined quantity of energy used from the battery power supply, and optionally the first predetermined quantity of energy is between 1 and 5% of the initial energy content of the battery power supply.

6. The battery powered electronic device of claim 5, wherein the second predetermined quantity of energy is greater than the first predetermined quantity of energy and is between 12 and 25% of the initial energy content of the battery power supply.

7. The battery powered electronic device of any one of claims 3 to 6, wherein the device is also configured to identify the battery power supply by determining the type of battery in the battery power supply.

8. The battery powered electronic device of claim 7, wherein the type of battery is determined based on a comparison of a measured voltage drop with a stored reference value for alkaline batteries.

9. The battery powered electronic device of claim 7, wherein the type of battery is determined based on a comparison of results of the comparison of battery voltage measurements with stored reference values for known types of batteries, and optionally wherein reference values are stored for known types of batteries of at least two different battery chemistries.

10. The battery powered electronic device of any one of claims 3 to 9, wherein the device is configured to identify at least alkaline and lithium battery chemistries.

11. The battery powered electronic device of any one of the preceding claims, wherein the device is configured to estimate the amount of energy consumed by the first part of the device based on knowledge of the energy usage of the first part in each of a sleep state and one or more active states.

12. The battery powered electronic device of claim 11, wherein the one or more active states include a radio receiving state and a radio transmitting state.

13. The battery powered electronic device of claim 11 or claim 12, wherein the device is configured to estimate the amount of energy consumed by the first part of the device based on knowledge of the energy usage of the first part in an idle state.

14. The battery powered electronic device of any one of the preceding claims, further comprising a store that stores a power usage value for the first part in each of the multiple activity states.

15. The battery powered electronic device of any one of the preceding claims, wherein the device is an intelligent peripheral of a security monitoring system, and optionally the second part comprises an image sensor and a video processor, and optionally a Wi-Fi transceiver.

16. The battery powered electronic device of claim 15, wherein the first part comprises a transceiver for communicating with a controller of the security monitoring system, optionally a transceiver operating in ISM radio bands.

17. A method of determining battery status in a battery powered device having a first part that is always on and that includes an electronic controller to control the operation of the device, and a battery power supply, the method comprising:
using coulomb counting to determine the energy consumption of a second part of the device, the second part being energised only intermittently and using battery power only when energised;
estimating the amount of energy consumed by the first part of the device based on knowledge of the energy usage of the first part in each of the multiple activity states and the cumulative time spent in these states;
determining an initial energy capacity of the battery power supply based on an identification of the battery power supply; and
determining the remaining energy capacity of the battery power supply based on the determined initial energy capacity, the estimate of the amount of energy consumed by the first part, and the record from the fuel gauge of the amount of energy consumed by the second part.

18. The method of claim 17, wherein estimating the amount of energy consumed by the first part of the device is based on knowledge of the energy usage of the first part in each of a sleep state and one or more active states.

19. The method of claim 17 or claim 18, wherein the one or more active states include a radio receiving state and a radio transmitting state.

20. The method of any one of claims 17 to 19, wherein estimating the amount of energy consumed by the first part of the device is based on knowledge of the energy usage of the first part in an idle state.

21. The method of any one of claims 17 to 20, wherein estimating the amount of energy consumed by the first part of the device is based on power usage values for the first part in each of the multiple activity states.

22. The method of any one of claims 17 to 21, wherein estimating the amount of energy consumed by the first part of the device in each of the multiple activity states is based on activity periods as short as 1 millisecond, and optionally as short as 0.1 millisecond.

23. The method of any one of claims 17 to 21, wherein estimating the amount of energy consumed by the first part of the device in each of the multiple activity states is based on activity periods as short as the period of a system clock of the device.

24. The method of any one of claims 17 to 23, further comprising, if the remaining energy capacity is determined to be less than a predetermined amount, generating a signal to indicate that the battery power supply needs to be replaced.

25. The method of any one of claims 17 to 24, further comprising identify the battery power supply by determining the battery chemistry of the battery power supply.

26. The method of claim 25, wherein the device is configured to determine the battery chemistry by comparing battery voltage measurements made after a first interval from initial use of the battery power supply, and again after a second longer interval.

27. The method of claim 26, wherein the first interval corresponds to a first predetermined quantity of energy used from the battery power supply, and the second interval corresponds to a second predetermined quantity of energy used from the battery power supply, and optionally wherein the first predetermined quantity of energy is between 1 and 5% of the initial energy content of the battery power supply.

28. The method of claim 27, wherein the second predetermined quantity of energy is greater than the first predetermined quantity of energy and is between 12 and 25% of the initial energy content of the battery power supply.

29. The method of any one of claims 25to 28, wherein the battery power supply is identified by determining the type of battery in the battery power supply.

30. The method of claim 29, wherein determining the type of battery is based on a comparison of a measured voltage drop with a stored reference value for alkaline batteries.

31. The method of claim 29, wherein the type of battery is determined by comparing results of a comparison of battery voltage measurements with stored reference values for known types of batteries, and optionally further comprising comparing results of a comparison of battery voltage measurements with stored reference values for known types of batteries of at least two different battery chemistries.

32. The method of any one of claims 25 to 31, further comprising determining whether the chemistry is an alkaline or a lithium chemistry.

## Patentansprüche

1. Batteriebetriebene elektronische Vorrichtung, umfassend: einen ersten Teil, der eine elektronische Steuerung zum Steuern des Betriebs der Vorrichtung einschließt; einen zweiten, von der Steuerung gesteuerten Teil, der nur bei Energiezufuhr Batteriestrom verwendet und dem nur intermittierend Energie zugeführt wird;
wobei der Stromverbrauch des zweiten Teils größer ist als der des ersten Teils; eine Batteriestromzufuhr;
eine Kraftstoffanzeige zum Aufzeichnen des Betrags der vom zweiten Teil verbrauchten Energie, optional unter Verwendung einer Coulomb-Zählung, wobei die Kraftstoffanzeige nur aktiviert wird, wenn der zweite Teil aktiviert ist; eine Überwachungsanordnung, die von der Kraftstoffanzeige getrennt ist, zum Überwachen der Zeitdauer, die die Steuerung in jedem von mehreren Aktivitätszuständen verbringt;
wobei die Vorrichtung dazu konfiguriert ist:
den Betrag der vom ersten Teil verbrauchten Energie basierend auf der Kenntnis der Energienutzung des ersten Teils in jedem der mehreren Aktivitätszustände zu schätzen;
eine Anfangsenergiekapazität der Batteriestromzufuhr basierend auf einer Identifizierung der Batteriestromzufuhr zu bestimmen; und
die verbleibende Energiekapazität der Batteriestromzufuhr basierend auf der bestimmten Anfangsenergiekapazität, der Schätzung des Betrags der vom ersten Teil verbrauchten Energie und der Aufzeichnung des Betrags der vom zweiten Teil verbrauchten Energie durch die Kraftstoffanzeige zu bestimmen.

2. Batteriebetriebene elektronische Vorrichtung nach Anspruch 1, wobei die Vorrichtung im Falle des Bestimmens, dass die verbleibende Energiekapazität geringer als ein vorbestimmter Betrag ausfällt, ferner dazu konfiguriert ist, ein Signal zu generieren, um anzugeben, dass es Zeit ist, die Batteriestromzufuhr zu ersetzen.

3. Batteriebetriebene elektronische Vorrichtung nach Anspruch 1 oder Anspruch 2, wobei die Vorrichtung dazu konfiguriert ist, die Batteriestromzufuhr durch Bestimmen der Batteriechemie der Batteriestromzufuhr zu identifizieren.

4. Batteriebetriebene elektronische Vorrichtung nach Anspruch 3, wobei die Vorrichtung dazu konfiguriert ist, die Batteriechemie zu bestimmen, indem Batteriespannungsmessungen verglichen werden, die nach einem ersten Intervall ab der Anfangsverwendung der Batteriestromzufuhr und erneut nach einem zweiten längeren Intervall durchgeführt werden.

5. Batteriebetriebene elektronische Vorrichtung nach Anspruch 4, wobei das erste Intervall einer ersten vorbestimmten Menge an Energie entspricht, die aus der Batteriestromzufuhr verwendet wird, und das zweite Intervall einer zweiten vorbestimmten Menge an Energie entspricht, die aus der Batteriestromzufuhr verwendet wird, und wobei optional die erste vorbestimmte Menge an Energie zwischen 1 und 5 % des Anfangsenergiegehalts der Batteriestromzufuhr beträgt.

6. Batteriebetriebene elektronische Vorrichtung nach Anspruch 5, wobei die zweite vorbestimmte Menge an Energie größer ist als die erste vorbestimmte Menge an Energie und zwischen 12 und 25 % des Anfangsenergiegehalts der Batteriestromzufuhr beträgt.

7. Batteriebetriebene elektronische Vorrichtung nach einem der Ansprüche 3 bis 6, wobei die Vorrichtung auch dazu konfiguriert ist, die Batteriestromzufuhr zu identifizieren, indem sie den Typ von Batterie in der Batteriestromzufuhr bestimmt.

8. Batteriebetriebene elektronische Vorrichtung nach Anspruch 7, wobei der Typ von Batterie basierend auf einem Vergleich eines gemessenen Spannungsabfalls mit einem gespeicherten Referenzwert für Alkali-Batterien bestimmt wird.

9. Batteriebetriebene elektronische Vorrichtung nach Anspruch 7, wobei der Typ von Batterie basierend auf einem Vergleich von Ergebnissen des Vergleichs von Batteriespannungsmessungen mit gespeicherten Referenzwerten für bekannte Typen von Batterien bestimmt wird, und optional wobei Referenzwerte für bekannte Typen von Batterien von mindestens zwei verschiedenen Batteriechemien gespeichert werden.

10. Batteriebetriebene elektronische Vorrichtung nach einem der Ansprüche 3 bis 9, wobei die Vorrichtung dazu konfiguriert ist, mindestens Alkali- und Lithiumbatteriechemien zu identifizieren.

11. Batteriebetriebene elektronische Vorrichtung nach einem der vorstehenden Ansprüche, wobei die Vorrichtung dazu konfiguriert ist, den Betrag der vom ersten Teil der Vorrichtung verbrauchten Energie basierend auf der Kenntnis der Energienutzung des ersten Teils in jedem von einem Ruhezustand und einem oder mehreren aktiven Zuständen zu schätzen.

12. Batteriebetriebene elektronische Vorrichtung nach Anspruch 11, wobei der eine oder die mehreren aktiven Zustände einen Funkempfangszustand und einen Funksendungszustand einschließen.

13. Batteriebetriebene elektronische Vorrichtung nach Anspruch 11 oder Anspruch 12, wobei die Vorrichtung dazu konfiguriert ist, den Betrag der vom ersten Teil der Vorrichtung verbrauchten Energie basierend auf der Kenntnis der Energienutzung des ersten Teils in einem Leerlaufzustand zu schätzen.

14. Batteriebetriebene elektronische Vorrichtung nach einem der vorstehenden Ansprüche, die ferner einen Speicher umfasst, der einen Stromnutzungswert für den ersten Teil in jedem der mehreren Aktivitätszustände speichert.

15. Batteriebetriebene elektronische Vorrichtung nach einem der vorstehenden Ansprüche, wobei die Vorrichtung eine intelligente Peripherieeinrichtung eines Sicherheitsüberwachungssystems ist und optional der zweite Teil einen Bildsensor und einen Videoprozessor sowie optional einen Wi-Fi-Transceiver umfasst.

16. Batteriebetriebene elektronische Vorrichtung nach Anspruch 15, wobei der erste Teil einen Transceiver zum Kommunizieren mit einer Steuerung des Sicherheitsüberwachungssystems umfasst, optional einen Transceiver, der in ISM-Funkbändern arbeitet.

17. Verfahren zum Bestimmen des Batteriestatus in einer batteriebetriebenen Vorrichtung, die einen ersten Teil, der immer eingeschaltet ist und eine elektronische Steuerung zum Steuern des Betriebs der Vorrichtung einschließt, und eine Batteriestromzufuhr aufweist, wobei das Verfahren umfasst:
Verwenden von Coulomb-Zählung, um den Energieverbrauch eines zweiten Teils der Vorrichtung zu bestimmen, wobei dem zweiten Teil nur intermittierend Energie zugeführt wird und nur dann Batteriestrom verwendet wird, wenn ihm Energie zugeführt wird; Schätzen des Betrags der vom ersten Teil der Vorrichtung verbrauchten Energie basierend auf der Kenntnis der Energienutzung des ersten Teils in jedem der mehreren Aktivitätszustände und der kumulativen Zeit, die in diesen Zuständen verbracht wurde;
Bestimmen einer Anfangsenergiekapazität der Batteriestromzufuhr basierend auf einer Identifizierung der Batteriestromzufuhr; und
Bestimmen der verbleibenden Energiekapazität der Batteriestromzufuhr basierend auf der bestimmten Anfangsenergiekapazität, der Schätzung des Betrags der vom ersten Teil verbrauchten Energie und der Aufzeichnung des Betrags der vom zweiten Teil verbrauchten Energie durch die Kraftstoffanzeige.

18. Verfahren nach Anspruch 17, wobei das Schätzen des Betrags der vom ersten Teil der Vorrichtung verbrauchten Energie auf der Kenntnis der Energienutzung des ersten Teils in jedem von einem Ruhezustand und einem oder mehreren aktiven Zuständen basiert.

19. Verfahren nach Anspruch 17 oder Anspruch 18, wobei der eine oder die mehreren aktiven Zustände einen Funkempfangszustand und einen Funksendungszustand einschließen.

20. Verfahren nach einem der Ansprüche 17 bis 19, wobei das Schätzen des Betrags der vom ersten Teil der Vorrichtung verbrauchten Energie auf der Kenntnis der Energienutzung des ersten Teils in einem Leerlaufzustand basiert.

21. Verfahren nach einem der Ansprüche 17 bis 20, wobei das Schätzen des Betrags der vom ersten Teil der Vorrichtung verbrauchten Energie auf den Stromnutzungswerten für den ersten Teil in jedem der mehreren Aktivitätszustände basiert.

22. Verfahren nach einem der Ansprüche 17 bis 21, wobei das Schätzen des Betrags der vom ersten Teil der Vorrichtung in jedem der mehreren Aktivitätszustände verbrauchten Energie auf Aktivitätsperioden basiert, die so kurz wie 1 Millisekunde und optional so kurz wie 0,1 Millisekunden sind.

23. Verfahren nach einem der Ansprüche 17 bis 21, wobei das Schätzen des Betrags der vom ersten Teil der Vorrichtung in jedem der mehreren Aktivitätszustände verbrauchten Energie auf Aktivitätsperioden basiert, die so kurz wie die Periode eines Systemtaktes der Vorrichtung sind.

24. Verfahren nach einem der Ansprüche 17 bis 23, das im Falle des Bestimmens, dass die verbleibende Energiekapazität geringer als ein vorbestimmter Betrag bestimmt ausfällt, das Generieren eines Signal umfasst, um anzugeben, dass die Batteriestromzufuhr ausgetauscht werden muss.

25. Verfahren nach einem der Ansprüche 17 bis 24, das ferner umfasst, die Batteriestromzufuhr durch Bestimmen der Batteriechemie der Batteriestromzufuhr zu identifizieren.

26. Verfahren nach Anspruch 25, wobei die Vorrichtung dazu konfiguriert ist, die Batteriechemie zu bestimmen, indem Batteriespannungsmessungen verglichen werden, die nach einem ersten Intervall ab der Anfangsverwendung der Batteriestromzufuhr und erneut nach einem zweiten längeren Intervall durchgeführt werden.

27. Verfahren nach Anspruch 26, wobei das erste Intervall einer ersten vorbestimmten Menge an Energie entspricht, die aus der Batteriestromzufuhr verwendet wird, und das zweite Intervall einer zweiten vorbestimmten Menge an Energie entspricht, die aus der Batteriestromzufuhr verwendet wird, und optional wobei die erste vorbestimmte Menge an Energie zwischen 1 und 5 % des Anfangsenergiegehalts der Batteriestromzufuhr beträgt.

28. Verfahren nach Anspruch 27, wobei die zweite vorbestimmte Menge an Energie größer ist als die erste vorbestimmte Menge an Energie und zwischen 12 und 25 % des Anfangsenergiegehalts der Batteriestromzufuhr beträgt.

29. Verfahren nach einem der Ansprüche 25 bis 28, wobei die Batteriestromzufuhr durch Bestimmen des Typs von Batterie in der Batteriestromzufuhr identifiziert wird.

30. Verfahren nach Anspruch 29, wobei das Bestimmen des Typs von Batterie auf einem Vergleich eines gemessenen Spannungsabfalls mit einem gespeicherten Referenzwert für Alkali-Batterien basiert.

31. Verfahren nach Anspruch 29, wobei der Typ von Batterie durch Vergleichen von Ergebnissen eines Vergleichs von Batteriespannungsmessungen mit gespeicherten Referenzwerten für bekannte Typen von Batterien bestimmt wird, und wobei das Verfahren optional ferner das Vergleichen von Ergebnissen eines Vergleichs von Batteriespannungsmessungen mit gespeicherten Referenzwerten für bekannte Typen von Batterien von mindestens zwei verschiedenen Batteriechemien umfasst.

32. Verfahren nach einem der Ansprüche 25 bis 31, das ferner das Bestimmen umfasst, ob es sich bei der Chemie um eine Alkali- oder eine Lithiumchemie handelt.

## Revendications

1. Dispositif électronique alimenté par batterie comprenant : une première partie qui inclut un contrôleur électronique pour contrôler le fonctionnement du dispositif ;
une deuxième partie, contrôlée par le contrôleur, qui utilise l'énergie de la batterie uniquement quand elle est sous tension et qui n'est sous tension que par intermittence ;
dans lequel la consommation d'énergie de la deuxième partie est supérieure à celle de la première partie ;
une alimentation par batterie ;
une jauge d'énergie pour enregistrer la quantité d'énergie consommée par la deuxième partie, en utilisant facultativement un comptage de Coulomb, la jauge d'énergie n'étant activée que quand la deuxième partie est activée ; un agencement de surveillance, distinct de la jauge d'énergie, pour surveiller le temps que le contrôleur passe dans chacun des multiples états d'activité ;
le dispositif étant configuré pour :
estimer la quantité d'énergie consommée par la première partie sur la base de la connaissance de la consommation d'énergie de la première partie dans chacun des multiples états d'activité ;
déterminer une capacité d'énergie initiale de l'alimentation par batterie sur la base d'une identification de l'alimentation par batterie ; et
déterminer la capacité d'énergie restante de l'alimentation par batterie sur la base de la capacité d'énergie initiale déterminée, de l'estimation de la quantité d'énergie consommée par la première partie, et de l'enregistrement à partir de la jauge d'énergie de la quantité d'énergie consommée par la deuxième partie.

2. Dispositif électronique alimenté par batterie selon la revendication 1, dans lequel le dispositif est en outre configuré pour générer, si la capacité d'énergie restante est déterminée comme étant inférieure à une quantité prédéterminée, un signal afin d'indiquer qu'il est temps de remplacer l'alimentation par batterie.

3. Dispositif électronique alimenté par batterie selon la revendication 1 ou 2, dans lequel le dispositif est configuré pour identifier l'alimentation par batterie en déterminant la chimie de batterie de l'alimentation par batterie.

4. Dispositif électronique alimenté par batterie selon la revendication 3, dans lequel le dispositif est configuré pour déterminer la chimie de batterie en comparant les mesures de tension de batterie effectuées après un premier intervalle à partir de l'utilisation initiale de l'alimentation par batterie, et à nouveau après un deuxième intervalle plus long.

5. Dispositif électronique alimenté par batterie selon la revendication 4, dans lequel le premier intervalle correspond à une première quantité d'énergie prédéterminée utilisée provenant de l'alimentation par batterie, et le deuxième intervalle correspond à une deuxième quantité d'énergie prédéterminée utilisée provenant de l'alimentation par batterie, et facultativement la première quantité d'énergie prédéterminée est comprise entre 1 % et 5 % du contenu d'énergie initial de l'alimentation par batterie.

6. Dispositif électronique alimenté par batterie selon la revendication 5, dans lequel la deuxième quantité d'énergie prédéterminée est supérieure à la première quantité d'énergie prédéterminée et est comprise entre 12 % et 25 % du contenu d'énergie initial de l'alimentation par batterie.

7. Dispositif électronique alimenté par batterie selon l'une quelconque des revendications 3 à 6, dans lequel le dispositif est également configuré pour identifier l'alimentation par batterie en déterminant le type de batterie dans l'alimentation par batterie.

8. Dispositif électronique alimenté par batterie selon la revendication 7, dans lequel le type de batterie est déterminé sur la base de la comparaison d'une chute de tension mesurée à une valeur de référence stockée pour les batteries alcalines.

9. Dispositif électronique alimenté par batterie selon la revendication 7, dans lequel le type de batterie est déterminé sur la base de la comparaison des résultats de la comparaison de mesures de tension de batterie à des valeurs de référence stockées pour des types de batterie connus, et facultativement dans lequel des valeurs de référence sont stockées pour des types de batterie connus d'au moins deux chimies de batterie différentes.

10. Dispositif électronique alimenté par batterie selon l'une quelconque des revendications 3 à 9, dans lequel le dispositif est configuré pour identifier au moins des chimies de batterie alcaline et de batterie au lithium.

11. Dispositif électronique alimenté par batterie selon l'une quelconque des revendications précédentes, dans lequel le dispositif est configuré pour estimer la quantité d'énergie consommée par la première partie du dispositif sur la base de la connaissance de la consommation d'énergie de la première partie dans chaque état parmi un état de veille et un ou plusieurs états actifs.

12. Dispositif électronique alimenté par batterie selon la revendication 11, dans lequel lesdits un ou plusieurs états actifs incluent un état de réception radio et un état de transmission radio.

13. Dispositif électronique alimenté par batterie selon la revendication 11 ou 12, dans lequel le dispositif est configuré pour estimer la quantité d'énergie consommée par la première partie du dispositif sur la base de la connaissance de la consommation d'énergie de la première partie dans un état de repos.

14. Dispositif électronique alimenté par batterie selon l'une quelconque des revendications précédentes, comprenant en outre une mémoire qui stocke une valeur de consommation d'énergie pour la première partie dans chacun des multiples états d'activité.

15. Dispositif électronique alimenté par batterie selon l'une quelconque des revendications précédentes, dans lequel le dispositif est un périphérique intelligent d'un système de surveillance de sécurité, et facultativement la deuxième partie comprend un capteur d'image et un processeur vidéo, et facultativement un émetteur-récepteur Wi-Fi.

16. Dispositif électronique alimenté par batterie selon la revendication 15, dans lequel la première partie comprend un émetteur-récepteur pour communiquer avec un contrôleur du système de surveillance de sécurité, facultativement un émetteur-récepteur fonctionnant dans les bandes radio ISM.

17. Procédé de détermination de l'état de batterie dans un dispositif alimenté par batterie comportant une première partie qui est toujours allumée et qui inclut un contrôleur électronique pour contrôler le fonctionnement du dispositif, et une alimentation par batterie, le procédé comprenant :
l'utilisation d'un comptage de Coulomb pour déterminer la consommation d'énergie d'une deuxième partie du dispositif, la deuxième partie étant sous tension uniquement par intermittence et utilisant l'énergie de la batterie uniquement quand elle est sous tension ; l'estimation de la quantité d'énergie consommée par la première partie du dispositif sur la base de la connaissance de la consommation d'énergie de la première partie dans chacun des multiples états d'activité et du temps cumulé passé dans ces états ;
la détermination d'une capacité d'énergie initiale de l'alimentation par batterie sur la base d'une identification de l'alimentation par batterie ; et
la détermination de la capacité d'énergie restante de l'alimentation par batterie sur la base de la capacité d'énergie initiale déterminée, de l'estimation de la quantité d'énergie consommée par la première partie, et de l'enregistrement à partir de la jauge d'énergie de la quantité d'énergie consommée par la deuxième partie.

18. Procédé selon la revendication 17, dans lequel l'estimation de la quantité d'énergie consommée par la première partie du dispositif est basée sur la connaissance de la consommation d'énergie de la première partie dans chaque état parmi un état de veille et un ou plusieurs états actifs.

19. Procédé selon la revendication 17 ou 18, dans lequel lesdits un ou plusieurs états actifs incluent un état de réception radio et un état de transmission radio.

20. Procédé selon l'une quelconque des revendications 17 à 19, dans lequel l'estimation de la quantité d'énergie consommée par la première partie du dispositif est basée sur la connaissance de la consommation d'énergie de la première partie dans un état de repos.

21. Procédé selon l'une quelconque des revendications 17 à 20, dans lequel l'estimation de la quantité d'énergie consommée par la première partie du dispositif est basée sur des valeurs de consommation d'énergie pour la première partie dans chacun des multiples états d'activité.

22. Procédé selon l'une quelconque des revendications 17 à 21, dans lequel l'estimation de la quantité d'énergie consommée par la première partie du dispositif dans chacun des multiples états d'activité est basée sur des périodes d'activité aussi courtes que 1 milliseconde, et facultativement aussi courtes que 0,1 milliseconde.

23. Procédé selon l'une quelconque des revendications 17 à 21, dans lequel l'estimation de la quantité d'énergie consommée par la première partie du dispositif dans chacun des multiples états d'activité est basée sur des périodes d'activité aussi courtes que la période d'une horloge système du dispositif.

24. Procédé selon l'une quelconque des revendications 17 à 23, comprenant en outre, si la capacité d'énergie restante est déterminée comme étant inférieure à une quantité prédéterminée, la génération d'un signal pour indiquer que l'alimentation par batterie doit être remplacée.

25. Procédé selon l'une quelconque des revendications 17 à 24, comprenant en outre l'identification de l'alimentation par batterie en déterminant la chimie de batterie de l'alimentation par batterie.

26. Procédé selon la revendication 25, dans lequel le dispositif est configuré pour déterminer la chimie de batterie en comparant les mesures de tension de batterie effectuées après un premier intervalle à partir de l'utilisation initiale de l'alimentation par batterie, et à nouveau après un deuxième intervalle plus long.

27. Procédé selon la revendication 26, dans lequel le premier intervalle correspond à une première quantité d'énergie prédéterminée utilisée provenant de l'alimentation par batterie, et le deuxième intervalle correspond à une deuxième quantité d'énergie prédéterminée utilisée provenant de l'alimentation par batterie, et facultativement dans lequel la première quantité d'énergie prédéterminée est comprise entre 1 % et 5 % du contenu d'énergie initial de l'alimentation par batterie.

28. Procédé selon la revendication 27, dans lequel la deuxième quantité d'énergie prédéterminée est supérieure à la première quantité d'énergie prédéterminée et est comprise entre 12 % et 25 % du contenu d'énergie initial de l'alimentation par batterie.

29. Procédé selon l'une quelconque des revendications 25 à 28, dans lequel l'alimentation par batterie est identifiée en déterminant le type de batterie dans l'alimentation par batterie.

30. Procédé selon la revendication 29, dans lequel la détermination du type de batterie est basée sur la comparaison d'une chute de tension mesurée à une valeur de référence stockée pour les batteries alcalines.

31. Procédé selon la revendication 29, dans lequel le type de batterie est déterminé en comparant les résultats de la comparaison de mesures de tension de batterie à des valeurs de référence stockées pour des types de batterie connus, et comprenant en outre facultativement la comparaison des résultats de la comparaison de mesures de tension de batterie à des valeurs de référence stockées pour des types de batterie connus d'au moins deux chimies de batterie différentes.

32. Procédé selon l'une quelconque des revendications 25 à 31, comprenant en outre la détermination du fait que la chimie est une chimie alcaline ou une chimie au lithium.
